# EUROPEAN PATENT APPLICATION

(11) **EP 4 779 623 A1**
(43) Date of publication of application: **22.07.2026**
(21) Application number: 26150877.4
(22) Date of filing: 08.01.2026
(51) Int. Cl.: G09G 3/32

(54) **DISPLAY DEVICE AND ELECTRONIC DEVICE**

(30) Priority: 21.01.2025 KR 20250008499
(71) Applicant: Samsung Display Co., Ltd., Yongin-si, Gyeonggi-do 17113 (KR)
(72) Inventor: LIM, Jaekeun, Yongin-si (KR); GU, Bon-Seog, Yongin-si (KR); ROH, Jinyoung, Yongin-si (KR); YANG, Jin-Wook, Yongin-si (KR)
(74) Representative: Marks & Clerk LLP

(57) **Abstract**

A display device includes a data driver to provide data voltages, a scan driver to sequentially provide scan signals, and a controller to control the data driver and the scan driver, wherein a scan driver stage includes an input circuit to transfer an input signal to a control node in response to a clock signal, a node-controlling circuit to provide a high gate voltage to an inverted control node when a voltage of the control node has a low level, and to provide a low gate voltage to the inverted control node when voltages of the control node and the clock signal have the high level, and an output circuit to output the high gate voltage as the scan signal in response to a voltage of the inverted control node, and to output the low gate voltage as the scan signal in response to the voltage of the control node.

## Description

### BACKGROUND

### 1. Field

Embodiments of the present disclosure relate to a display device including a scan driver, and an electronic device including the display device.

### 2. Description of the Related Art

To reduce the number of output channels of a data driver, a demultiplexing driving technique has been developed, which selectively connects each output channel to one of two or more data lines by using a demultiplexer circuit. The demultiplexer circuit may sequentially connect each output channel to the two or more data lines in a time-division manner within each horizontal time. Accordingly, a display device to which the demultiplexing driving technique is applied may have a smaller number of output channels than the number of data lines.

However, in a display device including the demultiplexer circuit, a size of a non-display region of a display panel may increase because the demultiplexer circuit is arranged in the non-display region, and power consumption may increase to perform a demultiplexing operation. Accordingly, a display panel in which a plurality of pixels performs a demultiplexing operation without the demultiplexer circuit is being developed.

### SUMMARY

Some embodiments provide a display device including a scan driver capable of generating scan signals suitable for a display panel that performs a demultiplexing operation without a demultiplexer circuit.

Some embodiments provide an electronic device including the display device.

According to embodiments, there is provided a display device including a display panel including pixels, a data driver configured to provide data voltages to the pixels, a scan driver including stages configured to sequentially provide scan signals to the pixels, and a controller configured to control the data driver and the scan driver, wherein at least one stage of the stages includes an input circuit configured to transfer an input signal to a control node in response to a clock signal, a node-controlling circuit configured to provide a high gate voltage to an inverted control node when a voltage of the control node has a low level, and to provide a low gate voltage to the inverted control node when the voltage of the control node has a high level and the clock signal has the high level, and an output circuit configured to output the high gate voltage as a corresponding scan signal among the scan signals in response to a voltage of the inverted control node, and to output the low gate voltage as the corresponding scan signal in response to the voltage of the control node.

A time point at which the voltage of the inverted control node is changed from the high level to the low level may be delayed by a low period of the clock signal from a time point at which the voltage of the control node is changed from the low level to the high level.

A time point at which the voltage of the inverted control node is changed from the high level to the low level may be delayed by half of a horizontal time from a time point at which the voltage of the control node is changed from the low level to the high level.

A time length of a high period of the corresponding scan signal may be equal to a time length of a high period of the clock signal.

A high period of the corresponding scan signal of the at least one stage may overlap a high period of a scan signal of another stage among the stages during half of a horizontal time.

The node-controlling circuit may include a first transistor configured to provide the high gate voltage to the inverted control node when the voltage of the control node has the low level, a second transistor configured to be turned on when the clock signal has the high level, and a third transistor connected in series with the second transistor between the inverted control node and a line configured to transfer the low gate voltage, and configured to be turned on when the voltage of the control node has the low level.

The first transistor may include a gate connected to the control node, a first terminal configured to receive the high gate voltage, and a second terminal connected to the inverted control node, wherein the second transistor includes a gate configured to receive the clock signal, a first terminal connected to the inverted control node, and a second terminal, and wherein the third transistor includes a gate connected to the control node, a first terminal connected to the second terminal of the second transistor, and a second terminal configured to receive the low gate voltage.

The first transistor may be a P-type metal-oxide-semiconductor transistor, wherein the second and third transistors are N-type metal-oxide-semiconductor transistors.

The node-controlling circuit may further include a first capacitor configured to hold the voltage of the inverted control node, and a fourth transistor configured to provide the low gate voltage to the inverted control node in response to a reset signal.

The first capacitor may include a first electrode configured to receive the high gate voltage, and a second electrode connected to the inverted control node, wherein the fourth transistor includes a gate configured to receive the reset signal, a first terminal connected to the inverted control node, and a second terminal configured to receive the low gate voltage.

The input circuit may include a fifth transistor including a gate configured to receive the clock signal, a first terminal configured to receive the input signal, and a second terminal connected to the control node.

The at least one stage may further include a sixth transistor at the control node to separate the control node into a first control node and a second control node.

The sixth transistor may include a gate configured to receive the low gate voltage, a first terminal connected to the first control node, and a second terminal connected to the second control node.

The output circuit may include a seventh transistor including a gate connected to the inverted control node, a first terminal configured to receive the high gate voltage, and a second terminal connected to an output node for outputting the corresponding scan signal, a second capacitor including a first electrode connected to the second control node, and a second electrode connected to the output node, and an eighth transistor including a gate connected to the second control node, a first terminal connected to the output node, and a second terminal configured to receive the low gate voltage.

According to embodiments, there is provided a display device including a display panel including pixels, a data driver configured to provide data voltages to the pixels, a scan driver including stages configured to sequentially provide scan signals to the pixels, and a controller configured to control the data driver and the scan driver, wherein at least one stage of the stages includes a first transistor including a gate connected to a first control node, a first terminal configured to receive a high gate voltage, and a second terminal connected to an inverted control node, a second transistor including a gate configured to receive a clock signal, a first terminal connected to the inverted control node, and a second terminal, a third transistor including a gate connected to a second control node, a first terminal connected to the second terminal of the second transistor, and a second terminal configured to receive a low gate voltage, a first capacitor including a first electrode configured to receive the high gate voltage, and a second electrode connected to the inverted control node, a fourth transistor including a gate configured to receive a reset signal, a first terminal connected to the inverted control node, and a second terminal configured to receive the low gate voltage, a fifth transistor including a gate configured to receive the clock signal, a first terminal configured to receive an input signal, and a second terminal connected to the first control node, a sixth transistor including a gate configured to receive the low gate voltage, a first terminal connected to the first control node, and a second terminal connected to the second control node, a seventh transistor including a gate connected to the inverted control node, a first terminal configured to receive the high gate voltage, and a second terminal connected to an output node for outputting a corresponding scan signal, a second capacitor including a first electrode connected to the second control node, and a second electrode connected to the output node, and an eighth transistor including a gate connected to the second control node, a first terminal connected to the output node, and a second terminal configured to receive the low gate voltage.

A time length of a high period of the corresponding scan signal may be equal to a time length of a high period of the clock signal.

A high period of the corresponding scan signal of the at least one stage may overlap a high period of a scan signal of another stage among the stages during half of a horizontal time.

According to embodiments, there is provided an electronic device including a processor configured to provide input image data, and a display device configured to display an image based on the input image data, the display device including a display panel including a first pixel and a second pixel arranged in an N-th pixel row, N being an integer that is greater than or equal to 1, a data driver configured to provide data voltages to the first and second pixels, a scan driver including stages configured to sequentially provide scan signals to the first and second pixels, and a controller configured to control the data driver and the scan driver, wherein the first pixel includes a first storage capacitor, and a second pixel transistor configured to transfer a first data voltage from a data line to the first storage capacitor in response to an N-th scan signal among the scan signals, wherein the second pixel includes a second storage capacitor, and second-first and second-second pixel transistors connected in series between the data line and the second storage capacitor, and configured to transfer a second data voltage from the data line to the second storage capacitor in response to the N-th scan signal and an (N+1)-th scan signal among the scan signals, and wherein an N-th stage of the stages includes an input circuit configured to transfer an input signal to a control node in response to a clock signal, a node-controlling circuit configured to provide a high gate voltage to an inverted control node when a voltage of the control node has a low level, and to provide a low gate voltage to the inverted control node when the voltage of the control node has a high level and the clock signal has the high level, and an output circuit configured to output the high gate voltage as the N-th scan signal in response to a voltage of the inverted control node, and to output the low gate voltage as the N-th scan signal in response to the voltage of the control node.

Each of the first pixel and the second pixel may further include a first pixel transistor configured to generate a driving current based on the first data voltage stored in the first storage capacitor or the second data voltage stored in the second storage capacitor, a third pixel transistor configured to provide an initialization voltage in response to the N-th scan signal, and a light-emitting element configured to emit light based on the driving current.

The N-th stage may further include a sixth transistor configured to separate the control node into a first control node and a second control node, wherein the node-controlling circuit includes a first transistor including a gate connected to the first control node, a first terminal configured to receive the high gate voltage, and a second terminal connected to the inverted control node, a second transistor including a gate configured to receive the clock signal, a first terminal connected to the inverted control node, and a second terminal, a third transistor including a gate connected to the second control node, a first terminal connected to the second terminal of the second transistor, and a second terminal configured to receive the low gate voltage, a first capacitor including a first electrode configured to receive the high gate voltage, and a second electrode connected to the inverted control node, and a fourth transistor including a gate configured to receive a reset signal, a first terminal connected to the inverted control node, and a second terminal configured to receive the low gate voltage, wherein the input circuit includes a fifth transistor including a gate configured to receive the clock signal, a first terminal configured to receive an input signal, and a second terminal connected to the first control node, and wherein the output circuit includes a seventh transistor including a gate connected to the inverted control node, a first terminal configured to receive the high gate voltage, and a second terminal connected to an output node for outputting the N-th scan signal, a second capacitor including a first electrode connected to the second control node, and a second electrode connected to the output node, and an eighth transistor including a gate connected to the second control node, a first terminal connected to the output node, and a second terminal configured to receive the low gate voltage.

As described above, in a display device and an electronic device according to embodiments, a node-controlling circuit of a stage may provide a low gate voltage to an inverted control node when a voltage of a control node has a high level and when a clock signal has the high level, and an output circuit of the stage may output a scan signal having the high level during a high period of the clock signal. Accordingly, a high period of the scan signal of the stage may overlap a high period of a scan signal of another stage during half of a horizontal time, and a scan driver may generate scan signals suitable for a display panel that performs a demultiplexing operation without a demultiplexer circuit.

At least some of the above and other features of the invention are set out in the claims.

### BRIEF DESCRIPTION OF THE DRAWINGS

Illustrative, non-limiting embodiments will be more clearly understood from the following detailed description in conjunction with the accompanying drawings.
FIG. 1 is a circuit diagram illustrating a stage of a scan driver according to embodiments.
FIG. 2 is a timing diagram for describing an example of an operation of a stage of FIG. 1.
FIG. 3 is a circuit diagram for describing an example of an operation of a stage of FIG. 1 in a first time period.
FIG. 4 is a circuit diagram for describing an example of an operation of a stage of FIG. 1 in a second time period.
FIG. 5 is a circuit diagram for describing an example of an operation of a stage of FIG. 1 in a third time period.
FIG. 6 is a circuit diagram illustrating a stage of a scan driver according to embodiments.
FIG. 7 is a block diagram illustrating a display device according to embodiments.
FIG. 8 is a circuit diagram illustrating an example of a first pixel and a second pixel included in a display device according to embodiments.
FIG. 9 is a block diagram illustrating a scan driver according to embodiments.
FIG. 10 is a timing diagram for describing an example of an operation of first and second pixels illustrated in FIG. 7 and an operation of a scan driver illustrated in FIG. 9.
FIG. 11 is a block diagram illustrating a scan driver according to embodiments.
FIG. 12 is a timing diagram for describing an example of an operation of first and second pixels illustrated in FIG. 7 and an operation of a scan driver illustrated in FIG. 11.
FIG. 13 is a block diagram illustrating an electronic device including a display device according to embodiments.
FIG. 14 is a block diagram illustrating an example of an electronic device according to embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection.

For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "secondcategory (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and/or related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

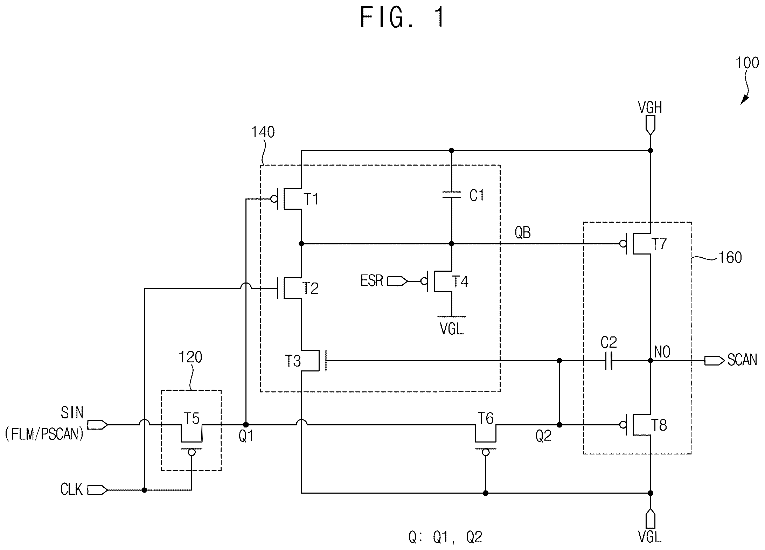

FIG. 1 is a circuit diagram illustrating a stage of a scan driver according to embodiments.

Referring to FIG. 1, a scan driver according to embodiments may include a plurality of stages. At least one stage 100 of the plurality of stages may include an input circuit 120 that transfers an input signal SIN to a control node Q in response to a clock signal CLK, a node-controlling circuit 140 that provides a high gate voltage VGH or a low gate voltage VGL to an inverted control node QB in response to a voltage of the control node Q and the clock signal CLK, and an output circuit 160 that outputs the high gate voltage VGH or the low gate voltage VGL as a scan signal SCAN in response to the voltage of the control node Q and a voltage of the inverted control node QB. In some embodiments, the stage 100 may further include a sixth transistor T6 located at the control node Q. The sixth transistor T6 may separate the control node Q into a first control node Q1 and a second control node Q2.

The input circuit 120 may transfer the input signal SIN to the first control node Q1 in response to the clock signal CLK. In some embodiments, the input signal SIN may be a start signal FLM in a case where the stage 100 is a first stage among the plurality of stages, and may be a scan signal PSCAN of a previous stage in a case where the stage 100 is one of subsequent stages. In some embodiments, the input circuit 120 may include a fifth transistor T5 that transfers the input signal SIN to the first control node Q1 when the clock signal CLK has a low level. For example, the fifth transistor T5 may include a gate that receives the clock signal CLK, a first terminal that receives the input signal SIN, and a second terminal connected to the first control node Q1.

The sixth transistor T6 may be connected between the first control node Q1 and the second control node Q2, and may include a gate that receives the low gate voltage VGL. Because a gate of the sixth transistor T6 receives the low gate voltage VGL for turning on the sixth transistor T6, the sixth transistor T6 may be referred to as an always-on transistor ("AOT"). In some embodiments, the sixth transistor T6 may include the gate that receives the low gate voltage VGL, a first terminal connected to the first control node Q1, and a second terminal connected to the second control node Q2.

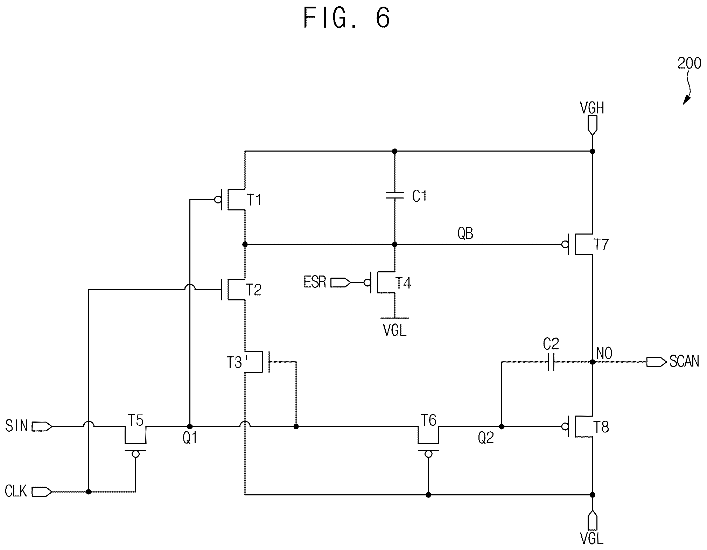

The node-controlling circuit 140 may provide the high gate voltage VGH to the inverted control node QB when a voltage of the first control node Q1 has the low level. Further, the node-controlling circuit 140 may provide the low gate voltage VGL to the inverted control node QB when a voltage of the second control node Q2 (or the voltage of the first control node Q1 in a stage 200 illustrated in FIG. 6) has a high level and the clock signal CLK has the high level. In some embodiments, the node-controlling circuit 140 may include a first transistor T1 that provides the high gate voltage VGH to the inverted control node QB when the voltage of the first control node Q1 has the low level, a second transistor T2 that is turned on when the clock signal CLK has the high level, and a third transistor T3 that is connected in series with the second transistor T2 between the inverted control node QB and a line that transfers the low gate voltage VGL and that is turned on when the voltage of the second control node Q2 has the low level. Thus, the second and third transistors T2 and T3 may provide the low gate voltage VGL to the inverted control node QB when the voltage of the second control node Q2 has the high level and the clock signal CLK has the high level. For example, the first transistor T1 may include a gate connected to the first control node Q1, a first terminal that receives the high gate voltage VGH, and a second terminal connected to the inverted control node QB, the second transistor T2 may include a gate that receives the clock signal CLK, a first terminal connected to the inverted control node QB, and a second terminal, and the third transistor T3 may include a gate connected to the second control node Q2, a first terminal connected to the second terminal of the second transistor T2, and a second terminal that receives the low gate voltage VGL.

In some embodiments, the node-controlling circuit 140 may further include a first capacitor C1 for holding the voltage of the inverted control node QB. For example, the first capacitor C1 may include a first electrode that receives the high gate voltage VGH, and a second electrode connected to the inverted control node QB. In some embodiments, the node-controlling circuit 140 may further include a fourth transistor T4 that provides the low gate voltage VGL to the inverted control node QB in response to a reset signal ESR. For example, the reset signal ESR may have the low level in a power-on period of a display device including the scan driver, and the fourth transistor T4 may provide the low gate voltage VGL to the inverted control node QB in response to the reset signal ESR having the low level in the power-on period. Further, for example, the fourth transistor T4 may include a gate that receives the reset signal ESR, a first terminal connected to the inverted control node QB, and a second terminal that receives the low gate voltage VGL.

The output circuit 160 may output the high gate voltage VGH as the scan signal SCAN in response to the voltage of the inverted control node QB, and may output the low gate voltage VGL as the scan signal SCAN in response to the voltage of the second control node Q2. In some embodiments, the output circuit 160 may include a seventh transistor T7 that outputs the high gate voltage VGH as the scan signal SCAN when the voltage of the inverted control node QB has the low level, a second capacitor C2 for boosting (or bootstrapping) the voltage of the second control node Q2 to a boosted low level, and an eighth transistor T8 that outputs the low gate voltage VGL as the scan signal SCAN when the voltage of the second control node Q2 has the low level (or the boosted low level). For example, the seventh transistor T7 may include a gate connected to the inverted control node QB, a first terminal that receives the high gate voltage VGH, and a second terminal connected to an output node NO from which the scan signal SCAN is output, the second capacitor C2 may include a first electrode connected to the second control node Q2, and a second electrode connected to the output node NO, and the eighth transistor T8 may include a gate connected to the second control node Q2, a first terminal connected to the output node NO, and a second terminal that receives the low gate voltage VGL.

In some embodiments, at least one of the first through eighth transistors T1 through T8 of the stage 100 may be implemented as a P-type metal-oxide-semiconductor ("PMOS") transistor, and at least another one of the first through eighth transistors T1 through T8 may be implemented as an N-type metal-oxide-semiconductor ("NMOS") transistor. For example, as illustrated in FIG. 1, the first, fourth, fifth, sixth, seventh and eighth transistors T1, T4, T5, T6, T7 and T8 may be PMOS transistors, and the second and third transistors T2 and T3 may be NMOS transistors, but are not limited thereto. In other embodiments, all of the first through eighth transistors T1 through T8 of the stage 100 may be PMOS transistors. In still other embodiments, all of the first through eighth transistors T1 through T8 of the stage 100 may be NMOS transistors.

Hereinafter, an example of an operation of the stage 100 of the scan driver according to embodiments is described below with reference to FIGS. 1 through 5.

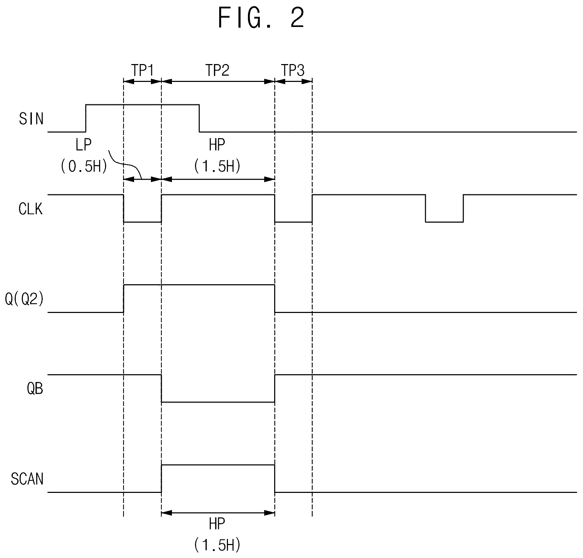

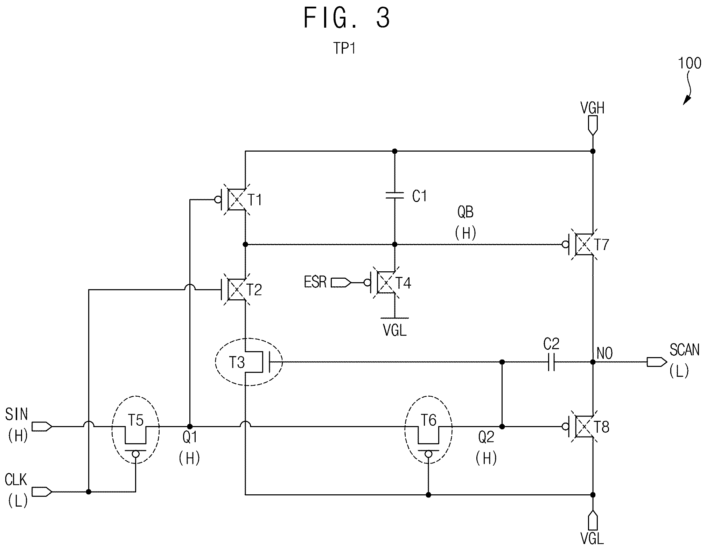

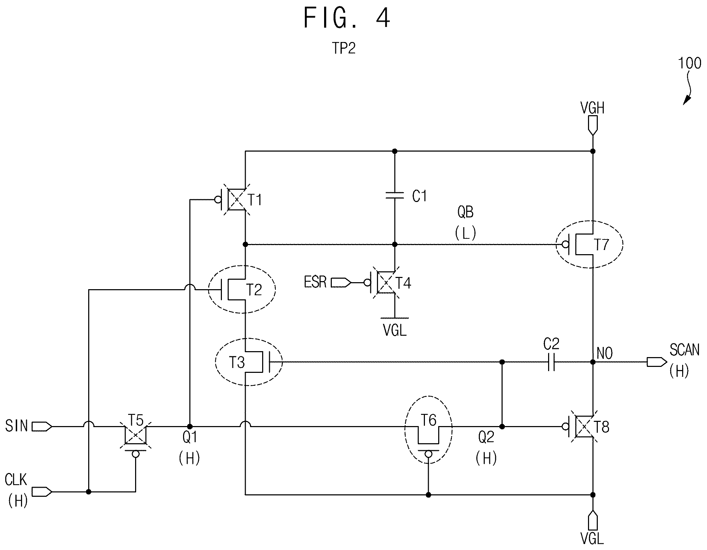

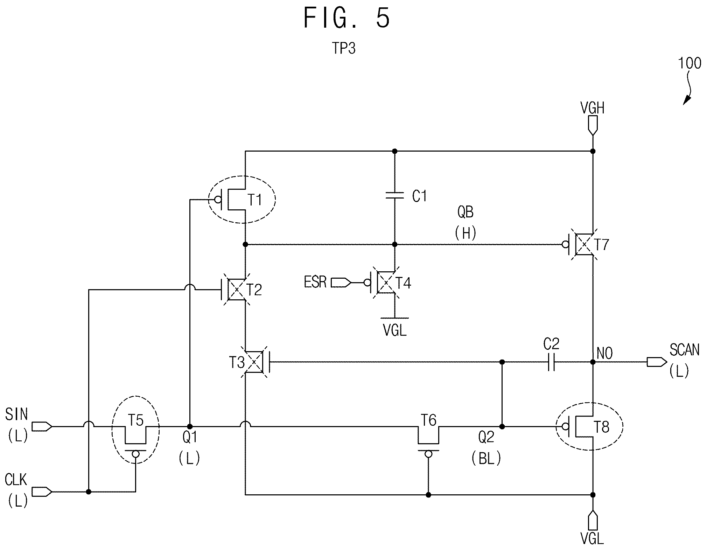

FIG. 2 is a timing diagram for describing an example of an operation of a stage of FIG. 1, FIG. 3 is a circuit diagram for describing an example of an operation of a stage of FIG. 1 in a first time period, FIG. 4 is a circuit diagram for describing an example of an operation of a stage of FIG. 1 in a second time period, and FIG. 5 is a circuit diagram for describing an example of an operation of a stage of FIG. 1 in a third time period.

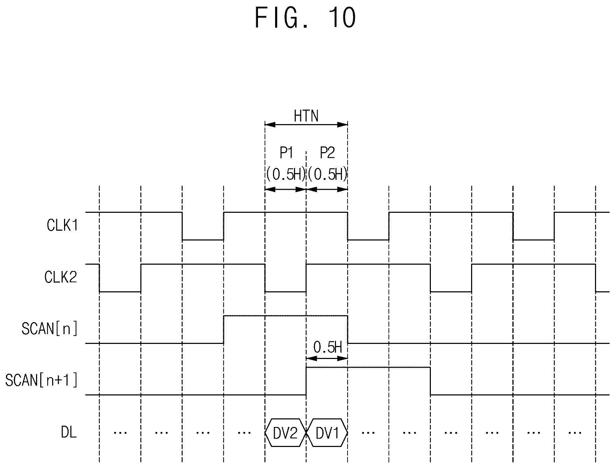

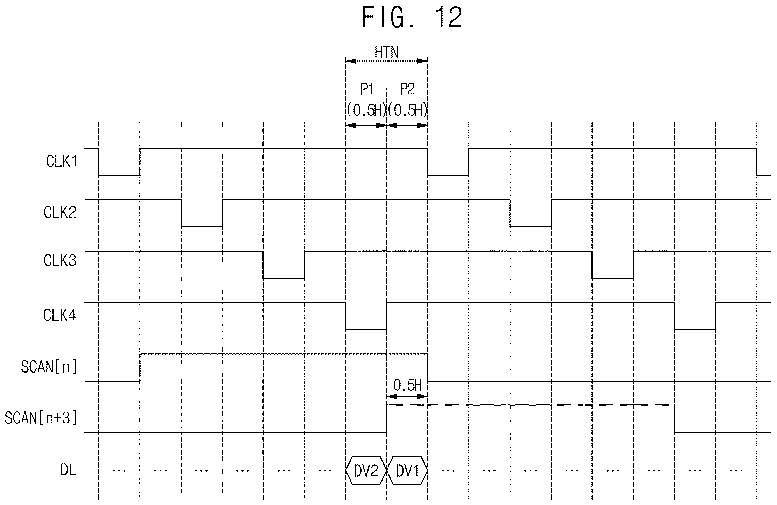

Referring to FIGS. 1 through 5, the stage 100 may output the scan signal SCAN by shifting the input signal SIN in response to the clock signal CLK. In some embodiments, as illustrated in FIGS. 2 and 10, the clock signal CLK may have a period (or a cycle) corresponding to about two horizontal times (e.g., 2H), and may periodically and repeatedly have a low period LP having a time length of about half of a horizontal time 0.5H, and a high period HP having a time length of about one-and-a-half horizontal times 1.5H, but is not limited thereto. Here, one horizontal time may be a time allocated to each pixel row of a display panel, and may be determined by dividing one frame period by the number of pixel rows of the display panel. In other embodiments, as illustrated in FIG. 12, the clock signal CLK may have a period (or a cycle) corresponding to about four horizontal times, and may have a low period LP having a time length of about half of a horizontal time and a high period HP having a time length of about three-and-a-half horizontal times, but is not limited thereto.

In a first time period TP1 in which the input signal SIN has the high level H and the clock signal CLK has the low level L, the voltage of the control node Q (e.g., the second control node Q2) may be changed from the low level L (or the boosted low level BL) to the high level H. For example, as illustrated in FIG. 3, the fifth transistor T5 may be turned on in response to the clock signal CLK having the low level L, and may transfer the input signal SIN having the high level H to the first control node Q1. Thus, the voltage of the first control node Q1 may have the high level H. Further, the sixth transistor T6 may be turned on in response to the low gate voltage VGL, and may transfer the voltage of the first control node Q1 having the high level H to the second control node Q2. Thus, the voltage of the second control node Q2 may have the high level H. The first transistor T1 may be turned off in response to the voltage of the first control node Q1 having the high level H, the fourth transistor T4 may be turned off in response to the reset signal ESR, and the eighth transistor T8 may be turned off in response to the voltage of the second control node Q2 having the high level H.

Further, the third transistor T3 may be turned on in response to the voltage of the second control node Q2 having the high level H, but the second transistor T2 may be turned off in response to the clock signal CLK having the low level L. Thus, the low gate voltage VGL may not be provided to the inverted control node QB, and the voltage of the inverted control node QB may be maintained at the previous level (e.g., at the high level H). In a case where the stage 100 does not include the second transistor T2 that operates in response to the clock signal CLK, the voltage of the inverted control node QB may be changed to the low level L when the voltage of the control node Q becomes the high level H. However, in the stage 100 of the scan driver according to embodiments, because the second transistor T2 is turned off during the low period LP of the clock signal CLK, a time point at which the voltage of the inverted control node QB is changed from the high level H to the low level L may be delayed by the low period LP of the clock signal CLK from a time point at which the voltage of the control node Q (e.g., the second control node Q2) is changed from the low level L (or the boosted low level BL) to the high level H. For example, as illustrated in FIG. 2, the low period LP of the clock signal CLK may have the time length of about half of a horizontal time 0.5H, and the time point at which the voltage of the inverted control node QB is changed from the high level H to the low level L may be delayed by about half of a horizontal time 0.5H from the time point at which the voltage of the control node Q is changed from the low level L (or the boosted low level BL) to the high level H. Thus, in the first time period TP1, the voltage of the inverted control node QB may have the high level H, the seventh transistor T7 may be turned off in response to the voltage of the inverted control node QB having the high level H, and the scan signal SCAN output from the output node NO may be maintained at a previous level, or the low level L.

In a second time period TP2 in which the clock signal CLK has the high level H, the voltage of the inverted control node QB may be changed from the high level H to the low level L, and the scan signal SCAN having the high level H may be output. For example, as illustrated in FIG. 4, the second transistor T2 may be turned on in response to the clock signal CLK having the high level H, and the third transistor T3 may be turned on in response to the voltage of the second control node Q2 having the high level H. Thus, the second and third transistors T2 and T3 may provide the low gate voltage VGL to the inverted control node QB, and the voltage of the inverted control node QB may be changed from the high level H to the low level L. The seventh transistor T7 may be turned on in response to the voltage of the inverted control node QB having the low level L, and may provide the high gate voltage VGH to the output node NO. Thus, the stage 100 may output the scan signal SCAN having the high level H during the high period HP of the clock signal CLK. That is, in the scan driver according to embodiments, a time length of a high period HP of the scan signal SCAN may be substantially the same as the time length of the high period HP of the clock signal CLK. For example, as illustrated in FIG. 2, in a case where the high period HP of the clock signal CLK has the time length of about one-and-a-half horizontal times 1.5H, the stage 100 may output the scan signal SCAN having the high level H during about one-and-a-half horizontal times 1.5H. Further, the first transistor T1 may be turned off in response to the voltage of the first control node Q1 having the high level H, the fourth transistor T4 may be turned off in response to the reset signal ESR, the fifth transistor T5 may be turned off in response to the clock signal CLK having the high level H, and the eighth transistor T8 may be turned off in response to the voltage of the second control node Q2 having the high level H.

In a third time period TP3 in which the input signal SIN has the low level L and the clock signal CLK has the low level L, the voltage of the control node Q (e.g., the second control node Q2) may be changed from the high level H to the low level L (or the boosted low level BL), the voltage of the inverted control node QB may be changed from the low level L to the high level H, and the scan signal SCAN having the low level L may be output. For example, as illustrated in FIG. 5, the fifth transistor T5 may be turned on in response to the clock signal CLK having the low level L, and may transfer the input signal SIN having the low level L to the first control node Q1. Thus, the voltage of the first control node Q1 may have the low level L. Further, the sixth transistor T6 may be turned on in response to the low gate voltage VGL, and may transfer the voltage of the first control node Q1 having the low level L to the second control node Q2. Thus, the voltage of the second control node Q2 may have the low level L. The eighth transistor T8 may be turned on in response to the voltage of the second control node Q2 having the low level L, and may provide the low gate voltage VGL to the output node NO. Thus, the voltage of the output node NO, or a voltage of the second electrode of the second capacitor C2 connected to the output node NO may be decreased. Further, when the voltage of the second electrode of the second capacitor C2 is decreased, the voltage of the second control node Q2 connected to the first electrode of the second capacitor C2 also may be decreased from the low level L to the boosted low level BL. This operation of decreasing or boosting the voltage of the second control node Q2 may be referred to as a boosting operation or a bootstrapping operation. Further, the eighth transistor T8 may be fully or completely turned on in response to the voltage of the second control node Q2 having the boosted low level BL, and the eighth transistor T8 may output the low gate voltage VGL as the scan signal SCAN. The low gate voltage VGL applied to the gate of the sixth transistor T6 may be higher than the voltage of the second control node Q2 having the boosted low level BL, and thus the sixth transistor T6 may be turned off. Accordingly, the voltage of the second control node Q2 having the boosted low level BL may not be transferred to the first control node Q1.

The first transistor T1 may be turned on in response to the voltage of the first control node Q1 having the low level L, and may provide the high gate voltage VGH to the inverted control node QB. Thus, the voltage of the inverted control node QB may have the high level H. Further, the second transistor T2 may be turned off in response to the clock signal CLK having the low level L, the third transistor T3 may be turned off in response to the voltage of the second control node Q2 having the boosted low level BL, the fourth transistor T4 may be turned off in response to the reset signal ESR, and the seventh transistor T7 may be turned off in response to the voltage of the inverted control node QB having the high level H.

In this manner, the plurality of stages of the scan driver may sequentially output the scan signals SCAN while delaying or shifting the scan signals SCAN by one horizontal time. In some embodiments, the high period HP of the scan signal SCAN of the stage 100 may overlap a high period of a scan signal of another stage among the plurality of stages during about half of a horizontal time 0.5H. For example, as illustrated in FIGS. 2 and 10, in a case where the stage 100 provides the scan signal SCAN to an N-th pixel row of a display panel, where N is an integer that is greater than or equal to 1, and the clock signal CLK has a period corresponding to about two horizontal times and periodically and repeatedly has a low period LP having a time length of about half of a horizontal time 0.5H and a high period HP having a time length of about one-and-a-half horizontal times 1.5H, the high period of the N-th scan signal SCAN[n] of the stage 100 may overlap a high period of an (N+1)-th scan signal SCAN[n+1] for an (N+1)-th pixel row during about half of a horizontal time 0.5H. In another example, as illustrated in FIG. 12, in a case where the stage 100 provides the scan signal SCAN to the N-th pixel row of the display panel, and the clock signal CLK has a period corresponding to about four horizontal times and periodically and repeatedly has a low period having a time length of about half of a horizontal time and a high period having a time length of about three-and-a-half horizontal times, the high period of the N-th scan signal SCAN[n] of the stage 100 may overlap a high period of an (N+3)-th scan signal SCAN[n+3] for an (N+3)-th pixel row during about half of a horizontal time 0.5H. The display panel may perform a demultiplexing operation using scan signals (e.g., the N-th and (N+1)-th scan signals SCAN[n] and SCAN[n+1] illustrated in FIG. 10) that overlap each other during about half of a horizontal time 0.5H without a demultiplexer circuit, and the scan driver according to embodiments may generate the scan signals suitable for the display panel that performs the demultiplexing operation without the size and complexity of a demultiplexer circuit. Such a display panel can thus have a reduced size of a peripheral region, and/or reduced power usage, relative to a comparative system which includes a demultiplexer circuit.

FIG. 6 is a circuit diagram illustrating a stage of a scan driver according to embodiments.

Referring to FIG. 6, a stage 200 of a scan driver according to embodiments may include a first transistor T1, a second transistor T2, a third transistor T3', a fourth transistor T4, a fifth transistor T5, a sixth transistor T6, a seventh transistor T7, an eighth transistor T8, a first capacitor C1 and a second capacitor C2. The stage 200 of FIG. 6 may have substantially the same configuration and substantially the same operation as a stage 100 of FIG. 1, except that a gate of the third transistor T3' may be connected to a first control node Q1. The third transistor T3' may be turned on in response to a voltage of the first control node Q1. In some embodiments, the third transistor T3' may include a gate connected to the first control node Q1, a first terminal connected to a second terminal of the second transistor T2, and a second terminal that receives a low gate voltage VGL.

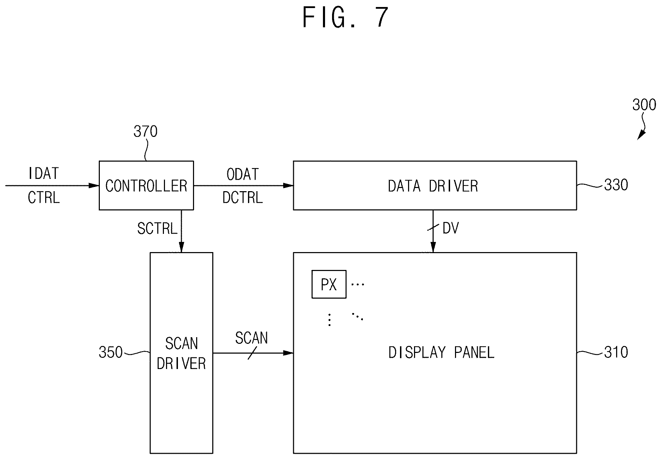

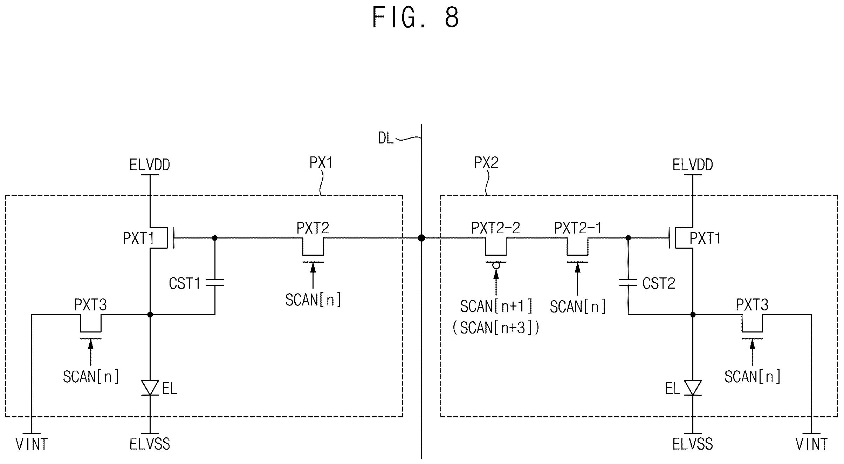

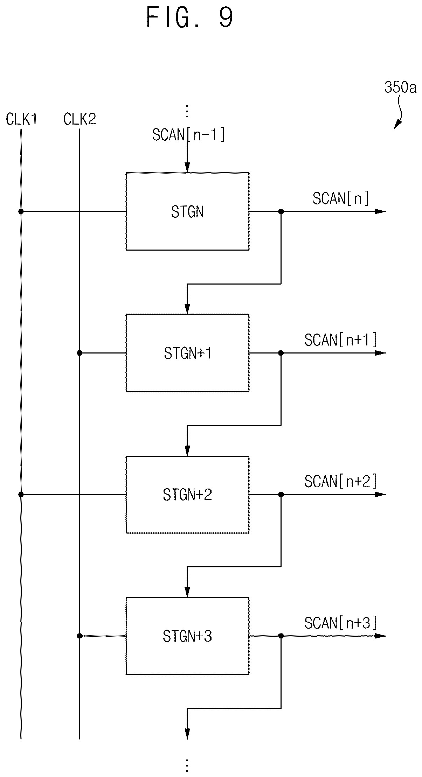

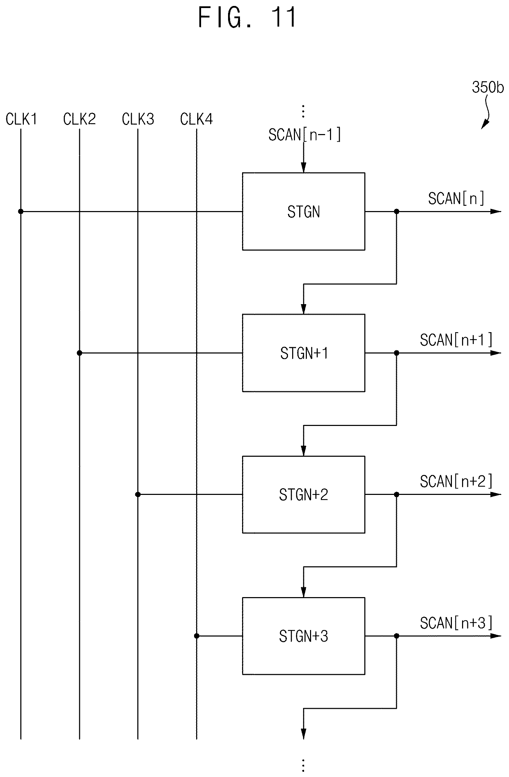

FIG. 7 is a block diagram illustrating a display device according to embodiments, FIG. 8 is a circuit diagram illustrating an example of a first pixel and a second pixel included in a display device according to embodiments, FIG. 9 is a block diagram illustrating a scan driver according to embodiments, FIG. 10 is a timing diagram for describing an example of an operation of first and second pixels illustrated in FIG. 7 and an operation of a scan driver illustrated in FIG. 9, FIG. 11 is a block diagram illustrating a scan driver according to embodiments, and FIG. 12 is a timing diagram for describing an example of an operation of first and second pixels illustrated in FIG. 7 and an operation of a scan driver illustrated in FIG. 11.

Referring to FIG. 7, a display device 300 according to embodiments may include a display panel 310 that includes a plurality of pixels PX, a data driver 330 that provides data voltages DV to the plurality of pixels PX, a scan driver 350 that provides scan signals SCAN to the plurality of pixels PX, and a controller 370 that controls the data driver 330 and the scan driver 350.

The display panel 310 may include data lines, scan lines, and the plurality of pixels PX connected to the data lines and the scan lines. The display panel 310 may perform a demultiplexing operation without a demultiplexer circuit. In some embodiments, the number of the data lines may correspond to half the number of pixel columns, and two adjacent pixels PX arranged in the same pixel row may be connected to the same data line.

For example, as illustrated in FIG. 8, a first pixel PX1 and a second pixel PX2 arranged in an N-th pixel row may be connected to the same data line DL, where N is an integer that is greater than or equal to 1. The first pixel PX1 may include a first storage capacitor CST1, and a second pixel transistor PXT2 that transfers a first data voltage from the data line DL to the first storage capacitor CST1 in response to an N-th scan signal SCAN[n]. The second pixel PX2 may include a second storage capacitor CST2, and second-first and second-second pixel transistors PXT2-1 and PXT2-2 that are connected in series between the data line DL and the second storage capacitor CST2 and that transfer a second data voltage from the data line DL to the second storage capacitor CST2 in response to the N-th scan signal SCAN[n] and an (N+1)-th scan signal SCAN[n+1] (or an (N+3)-th scan signal SCAN[n+3]). For example, the second pixel transistor PXT2 may include a gate that receives the N-th scan signal SCAN[n], a first terminal connected to the data line DL, and a second terminal connected to the first storage capacitor CST1. Further, the second-first pixel transistor PXT2-1 may include a gate that receives the N-th scan signal SCAN[n], a first terminal, and a second terminal connected to the second storage capacitor CST2, and the second-second pixel transistor PXT2-2 may include a gate that receives the (N+1)-th scan signal SCAN[n+1] (or the (N+3)-th scan signal SCAN[n+3]), a first terminal connected to the data line DL, and a second terminal connected to the first terminal of the second-first pixel transistor PXT2-1. In some embodiments, the second pixel transistor PXT2 and the second-first pixel transistor PXT2-1 may be NMOS transistors, and the second-second pixel transistor PXT2-2 may be a PMOS transistor. As illustrated in FIGS. 10 and 12, the display panel 310 including the first and second pixels PX1 and PX2 may perform a demultiplexing operation that provides the first and second data voltages DV1 and DV2 to the first and second pixels PX1 and PX2 in a time-division manner within an N-th horizontal time HTN allocated to the N-th pixel row without a demultiplexer circuit.

In some embodiments, each of the first pixel PX1 and the second pixel PX2 may further include a first pixel transistor PXT1, a third pixel transistor PXT3 and a light-emitting element EL. The first pixel transistor PXT1 of the first pixel PX1 may generate a driving current based on the first data voltage DV1 stored in the first storage capacitor CST1, and the first pixel transistor PXT1 of the second pixel PX2 may generate a driving current based on the second data voltage DV2 stored in the second storage capacitor CST2. For example, the first pixel transistor PXT1 of the first pixel PX1 may include a gate connected to a first electrode of the first storage capacitor CST1, a first terminal that receives a first power supply voltage ELVDD (e.g., a high power supply voltage), and a second terminal connected to a second electrode of the first storage capacitor CST1, and the first pixel transistor PXT1 of the second pixel PX2 may include a gate connected to a first electrode of the second storage capacitor CST2, a first terminal that receives the first power supply voltage ELVDD, and a second terminal connected to a second electrode of the second storage capacitor CST2.

The third pixel transistor PXT3 of the first pixel PX1 may provide an initialization voltage VINT to the second terminal of the first pixel transistor PXT1 of the first pixel PX1 in response to the N-th scan signal SCAN[n], and the third pixel transistor PXT3 of the second pixel PX2 may provide the initialization voltage VINT to the second terminal of the first pixel transistor PXT1 of the second pixel PX2 in response to the N-th scan signal SCAN[n]. For example, the third pixel transistor PXT3 of the first pixel PX1 may include a gate that receives the N-th scan signal SCAN[n], a first terminal connected to the second terminal of the first pixel transistor PXT1 of the first pixel PX1, and a second terminal that receives the initialization voltage VINT, and the third pixel transistor PXT3 of the second pixel PX2 may include a gate that receives the N-th scan signal SCAN[n], a first terminal connected to the second terminal of the first pixel transistor PXT1 of the second pixel PX2, and a second terminal that receives the initialization voltage VINT.

The light-emitting element EL of the first pixel PX1 may emit light based on the driving current generated by the first pixel transistor PXT1 of the first pixel PX1, and the light-emitting element EL of the second pixel PX2 may emit light based on the driving current generated by the first pixel transistor PXT1 of the second pixel PX2. In some embodiments, the light-emitting element EL may be an organic light-emitting diode ("OLED"). In other embodiments, the light-emitting element EL may be a nano light-emitting diode ("nano-LED"), a quantum dot ("QD") light-emitting diode, a micro light-emitting diode, an inorganic light-emitting diode, or any other suitable light-emitting element. For example, the light-emitting element EL of the first pixel PX1 may include an anode connected to the second terminal of the first pixel transistor PXT1 of the first pixel PX1, and a cathode that receives a second power supply voltage ELVSS (e.g., a low power supply voltage), and the light-emitting element EL of the second pixel PX2 may include an anode connected to the second terminal of the first pixel transistor PXT1 of the second pixel PX2 and a cathode that receives the second power supply voltage ELVSS.

Although FIG. 8 illustrates an example of the first and second pixels PX1 and PX2 performing the demultiplexing operation without the demultiplexer circuit, the plurality of pixels PX included in the display device 300 according to embodiments are not limited to the example illustrated in FIG. 8.

The data driver 330 may generate the data voltages DV based on a data control signal DCTRL and output image data ODAT received from the controller 370, and may provide the data voltages DV to the plurality of pixels PX through the data lines. In some embodiments, the data control signal DCTRL may include, but is not limited to, an output data enable signal, a horizontal start signal and a load signal. In some embodiments, the data driver 330 and the controller 370 may be implemented as a single integrated circuit, and the single integrated circuit may be referred to as a timing controller embedded data driver ("TED") integrated circuit. In other embodiments, the data driver 330 and the controller 370 may be implemented as separate integrated circuits.

The scan driver 350 may include a plurality of stages. The plurality of stages may generate the scan signals SCAN based on a scan control signal SCTRL received from the controller 370, and may sequentially provide the scan signals SCAN to the plurality of pixels PX through the scan lines on a row-by-row basis. In some embodiments, the scan control signal SCTRL may include, but is not limited to, a start signal and a clock signal. In some embodiments, each of the plurality of stages may be a stage 100 of FIG. 1 or a stage 200 of FIG. 6. Further, in some embodiments, the scan driver 350 may be integrated or formed in the display panel 310. In other embodiments, the scan driver 350 may be implemented with one or more integrated circuits.

In some embodiments, as illustrated in FIGS. 9 and 10, a scan driver 350a may include a plurality of stages STGN, STGN+1, STGN+2 and STGN+3 that sequentially output scan signals SCAN[n], SCAN[n+1], SCAN[n+2] and SCAN[n+3] in response to a first clock signal CLK1 and a second clock signal CLK2. For example, each of the first and second clock signals CLK1 and CLK2 may have a period (or a cycle) corresponding to about two horizontal times, and may periodically and repeatedly have a low period having a time length of about half of a horizontal times and a high period having a time length of about one-and-a-half horizontal times. Further, an N-th stage STGN may output an N-th scan signal SCAN[n] by delaying or shifting an (N-1)-th scan signal SCAN[n-1] by one horizontal time in response to the first clock signal CLK1, an (N+1)-th stage STGN+1 may output an (N+1)-th scan signal SCAN[n+1] by delaying or shifting the N-th scan signal SCAN[n] by one horizontal time in response to the second clock signal CLK2, an (N+2)-th stage STGN+2 may output an (N+2)-th scan signal SCAN[n+2] by delaying or shifting the (N+1)-th scan signal SCAN[n+1] by one horizontal time in response to the first clock signal CLK1, and an (N+3)-th stage STGN+3 may output an (N+3)-th scan signal SCAN[n+3] by delaying or shifting the (N+2)-th scan signal SCAN[n+2] by one horizontal time in response to the second clock signal CLK2.

In the display device 300 including the scan driver 350a of FIG. 9, the first and second pixels PX1 and PX2 arranged in the N-th pixel row may perform the demultiplexing operation based on the N-th and (N+1)-th scan signals SCAN[n] and SCAN[n+1] that overlap each other during about half of a horizontal time 0.5H. In the N-th horizontal time HTN allocated to the N-th pixel row including the first and second pixels PX1 and PX2, the first and second data voltages DV1 and DV2 may be provided to the first and second pixels PX1 and PX2 in a time-division manner, respectively. For example, in a first period P1 of the N-th horizontal time HTN, the N-th scan signal SCAN[n] may have a high level, the (N+1)-th scan signal SCAN[n+1] may have a low level, the second transistor T2 of the first pixel PX1 may be turned on, the second-first and second-second transistors T2-1 and T2-2 of the second pixel PX2 may be turned on, and the second data voltage DV2 for the second pixel PX2 may be applied to the data line DL. Thus, in the first period P1 of the N-th horizontal time HTN, the first storage capacitor CST1 of the first pixel PX1 and the second storage capacitor CST2 of the second pixel PX2 may store the second data voltage DV2. Thereafter, in a second period P2 of the N-th horizontal time HTN, the N-th scan signal SCAN[n] may have the high level, the (N+1)-th scan signal SCAN[n+1] may have the high level, the second transistor T2 of the first pixel PX1 may be turned on, the second-first transistor T2-1 of the second pixel PX2 may be turned on, and the first data voltage DV1 for the first pixel PX1 may be applied to the data line DL. Thus, in the second period P2 of the N-th horizontal time HTN, a voltage stored in the first storage capacitor CST1 of the first pixel PX1 may be changed from the second data voltage DV2 to the first data voltage DV1 for the first pixel PX1. However, the second-second transistor T2-2 of the second pixel PX2 may be turned off in response to the (N+1)-th scan signal SCAN[n+1] having the high level, and the second storage capacitor CST2 of the second pixel PX2 may maintain the second data voltage DV2 that is previously stored in the first period P1 of the N-th horizontal time HTN. In this manner, the first and second pixels PX1 and PX2 may perform the demultiplexing operation based on the N-th and (N+1)-th scan signals SCAN[n] and SCAN[n+1].

In other embodiments, as illustrated in FIGS. 11 and 12, a scan driver 350b may include a plurality of stages STGN, STGN+1, STGN+2 and STGN+3 that sequentially output scan signals SCAN[n], SCAN[n+1], SCAN[n+2] and SCAN[n+3] in response to a first clock signal CLK1, a second clock signal CLK2, a third clock signal CLK3, and a fourth clock signal CLK4. For example, each of the first, second, third and fourth clock signals CLK1, CLK2, CLK3, and CLK4 may have a period (or a cycle) corresponding to about four horizontal times, and may periodically and repeatedly have a low period having a time length of about half of a horizontal time and a high period having a time length of about three-and-a-half horizontal times. Further, an N-th stage STGN may output an N-th scan signal SCAN[n] by delaying or shifting an (N-1)-th scan signal SCAN[n-1] by one horizontal time in response to the first clock signal CLK1, an (N+1)-th stage STGN+1 may output an (N+1)-th scan signal SCAN[n+1] by delaying or shifting the N-th scan signal SCAN[n] by one horizontal time in response to the second clock signal CLK2, an (N+2)-th stage STGN+2 may output an (N+2)-th scan signal SCAN[n+2] by delaying or shifting the (N+1)-th scan signal SCAN[n+1] by one horizontal time in response to the third clock signal CLK3, and an (N+3)-th stage STGN+3 may output an (N+3)-th scan signal SCAN[n+3] by delaying or shifting the (N+2)-th scan signal SCAN[n+2] by one horizontal time in response to the fourth clock signal CLK4. Although it is not illustrated in FIG. 11, subsequent (N+4)-th, (N+5)-th, (N+6)-th and (N+7)-th stages may output (N+4)-th, (N+5)-th, (N+6)-th and (N+7)-th scan signals in response to the first, second, third and fourth clock signals CLK1, CLK2, CLK3 and CLK4, respectively.

In the display device 300 including the scan driver 350b of FIG. 11, the first and second pixels PX1 and PX2 arranged in the N-th pixel row may perform the demultiplexing operation based on the N-th and (N+3)-th scan signals SCAN[n] and SCAN[n+3] that overlap each other during about half of a horizontal time 0.5H. In the N-th horizontal time HTN allocated to the N-th pixel row including the first and second pixels PX1 and PX2, the first and second data voltages DV1 and DV2 may be provided to the first and second pixels PX1 and PX2 in a time-division manner, respectively. For example, in the first period P1 of the N-th horizontal time HTN, the N-th scan signal SCAN[n] may have the high level, the (N+3)-th scan signal SCAN[n+3] may have the low level, and the first storage capacitor CST1 of the first pixel PX1 and the second storage capacitor CST2 of the second pixel PX2 may store the second data voltage DV2 for the second pixel PX2. Thereafter, in the second period P2 of the N-th horizontal time HTN, the N-th scan signal SCAN[n] may have the high level, the (N+3)-th scan signal SCAN[n+3] may have the high level, and the voltage stored in the first storage capacitor CST1 of the first pixel PX1 may be changed from the second data voltage DV2 to the first data voltage DV1 for the first pixel PX1. However, the second-second transistor T2-2 of the second pixel PX2 may be turned off in response to the (N+3)-th scan signal SCAN[n+3] having the high level, and the second storage capacitor CST2 of the second pixel PX2 may maintain the second data voltage DV2 that is previously stored in the first period P1 of the N-th horizontal time HTN. In this manner, the first and second pixels PX1 and PX2 may perform the demultiplexing operation based on the N-th and (N+3)-th scan signals SCAN[n] and SCAN[n+3].

Although FIGS. 9 and 10 illustrate an example of the scan driver 350a receiving two clock signals CLK1 and CLK2, and FIGS. 11 and 12 illustrate an example of the scan driver 350b receiving four clock signals CLK1, CLK2, CLK3 and CLK4, the scan driver 350 according to embodiments is not limited to the examples illustrated in FIGS. 9 through 12. For example, other numbers of clock signals may be received.

The controller 370 (e.g., a timing controller) may receive input image data IDAT and a control signal CTRL from an external processor (e.g., a graphics processing unit ("GPU"), an application processor ("AP") or a graphics card). In some embodiments, the input image data IDAT may be RGB image data including red image data, green image data and blue image data. In some embodiments, the control signal CTRL may include, but is not limited to, a vertical synchronization signal, a horizontal synchronization signal, an input data enable signal, a master clock signal, etc. The controller 370 may generate the output image data ODAT, the data control signal DCTRL and the scan control signal SCTRL based on the input image data IDAT and the control signal CTRL. The controller 370 may control an operation of the data driver 330 by providing the output image data ODAT and the data control signal DCTRL to the data driver 330, and may control an operation of the scan driver 350 by providing the scan control signal SCTRL to the scan driver 350.

As described above, in the display device 300 according to embodiments, the scan driver 350 may generate the scan signals (e.g., the N-th and (N+1)-th scan signals SCAN[n] and SCAN[n+1]) that overlap each other during about half of a horizontal time 0.5H with a simple configuration, and the display panel 310 may perform the demultiplexing operation by using the scan signals that overlap each other during about half of a horizontal time 0.5H without the demultiplexer circuit.

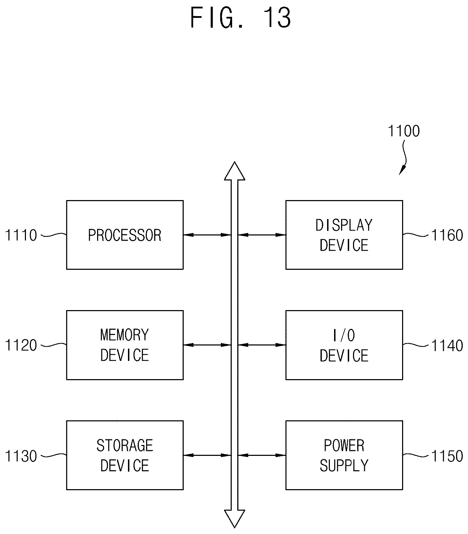

FIG. 13 is a block diagram illustrating an electronic device including a display device according to embodiments.

Referring to FIG. 13, an electronic device 1100 may include a processor 1110, a memory device 1120, a storage device 1130, an input/output (I/O) device 1140, a power supply 1150 and a display device 1160. The electronic device 1100 may further include a plurality of ports for communicating with a video card, a sound card, a memory card, a universal serial bus ("USB") device, other electric devices, etc.

The processor 1110 may perform various computing functions or tasks. The processor 1110 may be an application processor ("AP"), a micro-processor, a central processing unit ("CPU"), etc. The processor 1110 may be coupled to other components via an address bus, a control bus, a data bus, etc. Further, in some embodiments, the processor 1110 may be further coupled to an extended bus, such as a peripheral component interconnection ("PCI") bus. The processor 1110 may provide the input image data IDAT and the control signal CTRL to the controller 370 of FIG. 7.

The memory device 1120 may store data for operations of the electronic device 1100. For example, the memory device 1120 may include at least one non-volatile memory device, such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, etc., and/or at least one volatile memory device, such as a dynamic random access memory ("DRAM") device, a static random access memory ("SRAM") device, a mobile dynamic random access memory ("mobile DRAM") device, etc.

The storage device 1130 may be a solid state drive ("SSD") device, a hard disk drive ("HDD") device, a compact disc-read only memory ("CD-ROM") device, etc. The I/O device 1140 may be an input device, such as a keyboard, a keypad, a mouse, a touch screen, etc., and an output device, such as a printer, a speaker, etc. The power supply 1150 may supply power for operations of the electronic device 1100. The display device 1160 may be coupled to other components through the buses or other communication links.

In the display device 1160, a node-controlling circuit of a stage of a scan driver may provide a low gate voltage to an inverted control node when a voltage of a control node has a high level and a clock signal has the high level, and an output circuit of the stage may output a scan signal having the high level during a high period of the clock signal. Accordingly, a high period of the scan signal of the stage may overlap a high period of a scan signal of another stage during half of a horizontal time, and the scan driver may generate scan signals suitable for a display panel that performs a demultiplexing operation without a demultiplexer circuit.

The disclosed embodiments may be applied to any electronic device 1100 including the display device 1160. For example, the disclosed embodiments may be applied to a mobile phone, a smart phone, a personal computer ("PC") (e.g. a laptop computer, a tablet computer, etc.), a television ("TV") (e.g., a digital TV, a three-dimensional ("3D") TV, etc.), a home appliance, a virtual reality ("VR") device, an augmented reality ("AR") device, a mixed reality ("MR") device, an extended reality ("XR") device, a wearable electronic device, a personal digital assistant ("PDA"), a portable multimedia player ("PMP"), a digital camera, a music player, a portable game console, a navigation device, etc.

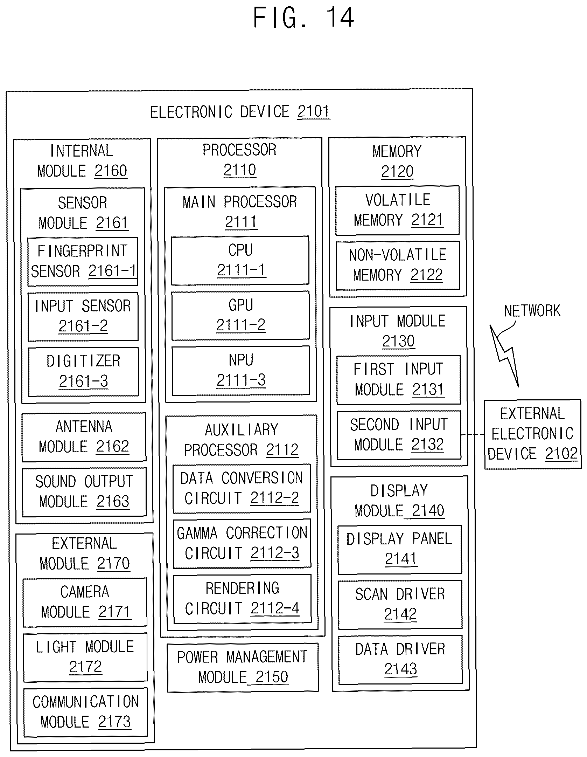

FIG. 14 is a block diagram illustrating an example of an electronic device according to embodiments.

An electronic device 2101 may output various information via a display module 2140 in an operating system. When a processor 2110 executes an application stored in a memory 2120, the display module 2140 may provide application information to a user via a display panel 2141.

The processor 2110 may obtain an external input via an input module 2130 or a sensor module 2161 and may execute an application corresponding to the external input. For example, when the user selects a camera icon displayed on the display panel 2141, the processor 2110 may obtain a user input via an input sensor 2161-2 and may activate a camera module 2171. The processor 2110 may transfer image data corresponding to an image captured by the camera module 2171 to the display module 2140. The display module 2140 may display an image corresponding to the captured image via the display panel 2141.

As another example, when personal information authentication is executed in the display module 2140, a fingerprint sensor 2161-1 may obtain fingerprint information of the user as input data. The processor 2110 may compare the input data obtained by the fingerprint sensor 2161-1 with authentication data stored in the memory 2120, and may execute an application according to the comparison result. The display module 2140 may display information executed according to application logic via the display panel 2141.

As still another example, when a music streaming icon displayed on the display module 2140 is selected, the processor 2110 obtains a user input via the input sensor 2161-2 and may activate a music streaming application stored in the memory 2120. When a music execution command is input in the music streaming application, the processor 2110 may activate a sound output module 2163 to provide sound information corresponding to the music execution command to the user.

In the above, an operation of the electronic device 2101 has been briefly described. Hereinafter, a configuration of the electronic device 2101 will be described in detail. Some components of the electronic device 2101 described below may be integrated and provided as one component, or one component may be provided separately as two or more components.

Referring to FIG. 14, the electronic device 2101 may communicate with an external electronic device 2102 via a network (e.g., a short-range wireless communication network or a long-range wireless communication network). In some embodiments, the electronic device 2101 may include the processor 2110, the memory 2120, the input module 2130, the display module 2140, a power management module 2150, an internal module 2160 and an external module 2170. In some embodiments, at least one of the components may be omitted from the electronic device 2101, or one or more other components may be added in the electronic device 2101. In some embodiments, some of the components (e.g., the sensor module 2161, an antenna module 2162, or the sound output module 2163) may be implemented as a single component (e.g., the display module 2140).

The processor 2110 may execute software to control at least one other component (e.g., a hardware or software component) of the electronic device 2101 coupled with the processor 2110, and may perform various data processing or computation. According to some embodiments, as at least part of the data processing or computation, the processor 2110 may store a command or data received from another component (e.g., the input module 2130, the sensor module 2161, or a communication module 2173) in a volatile memory 2121, may process the command or the data stored in the volatile memory 2121, and may store resulting data in a non-volatile memory 2122.

The processor 2110 may include a main processor 2111 and an auxiliary processor 2112. The main processor 2111 may include one or more of a central processing unit ("CPU") 2111-1 or an application processor ("AP"). The main processor 2111 may further include any one or more of a graphics processing unit ("GPU") 2111-2, a communication processor ("CP"), and an image signal processor ("ISP"). The main processor 2111 may further include a neural processing unit ("NPU") 2111-3. The NPU 2111-3 may be a processor specialized in processing an artificial intelligence model, and the artificial intelligence model may be generated through machine learning. The artificial intelligence model may include a plurality of artificial neural network layers. The artificial neural network may be a deep neural network ("DNN"), a convolutional neural network ("CNN"), a recurrent neural network ("RNN"), a restricted Boltzmann machine ("RBM"), a deep belief network ("DBN"), a bidirectional recurrent deep neural network ("BRDNN"), deep Q-network or a combination of two or more thereof, but is not limited thereto. The artificial intelligence model may, additionally or alternatively, include a software structure other than a hardware structure. At least two of the above-described processing units and processors may be implemented as an integrated component (e.g., a single chip), or respective processing units and processors may be implemented as independent components (e.g., a plurality of chips).

The auxiliary processor 2112 may include a controller. The controller included in the auxiliary processor 2112 may correspond to a controller 650 illustrated in FIG. 13. The controller may include an interface conversion circuit and a timing control circuit. The controller may receive an image signal from the main processor 2111, may convert a data format of the image signal to meet interface specifications with the display module 2140, and may output image data. The controller may output various control signals for driving the display module 2140.

The auxiliary processor 2112 may further include a data conversion circuit 2112-2, a gamma correction circuit 2112-3, a rendering circuit 2112-4, or the like. The data conversion circuit 2112-2 may receive image data from the controller. The data conversion circuit 2112-2 may compensate for the image data such that an image is displayed with a desired luminance according to characteristics of the electronic device 2101 or the user's setting, or may convert the image data to reduce power consumption or to eliminate an afterimage. The gamma correction circuit 2112-3 may convert image data or a gamma reference voltage so that an image displayed on the electronic device 2101 has desired gamma characteristics. The rendering circuit 2112-4 may receive image data from the controller, and may render the image data in consideration of a pixel arrangement of the display panel 2141 in the electronic device 2101. At least one of the data conversion circuit 2112-2, the gamma correction circuit 2112-3, or the rendering circuit 2112-4 may be integrated in another component (e.g., the main processor 2111 or the controller). At least one of the data conversion circuit 2112-2, the gamma correction circuit 2112-3, or the rendering circuit 2112-4 may be integrated in a data driver 2143 described below.

The memory 2120 may store various data used by at least one component (e.g., the processor 2110 or the sensor module 2161) of the electronic device 2101. The various data may include, for example, input data or output data for a command related thereto. The memory 2120 may include at least one of the volatile memory 2121 or the non-volatile memory 2122.

The input module 2130 may receive a command or data to be used by the components (e.g., the processor 2110, the sensor module 2161, or the sound output module 2163) of the electronic device 2101 from the outside of the electronic device 2101 (e.g., the user or the external electronic device 2102).

The input module 2130 may include a first input module 2131 for receiving a command or data from the user, and a second input module 2132 for receiving a command or data from the external electronic device 2102. The first input module 2131 may include a microphone, a mouse, a keyboard, a key (e.g., a button), or a pen (e.g., a passive pen or an active pen). The second input module 2132 may support a designated protocol capable of connecting the electronic device 2101 to the external electronic device 2102 by wire or wirelessly. In some embodiments, the second input module 2132 may include a high definition multimedia interface ("HDMI"), a universal serial bus ("USB") interface, an SD card interface, or an audio interface. The second input module 2132 may include a connector that may physically connect the electronic device 2101 to the external electronic device 2102. For example, the second input module 2132 may include an HDMI connector, a USB connector, an SD card connector, or an audio connector (e.g., a headphone connector).

The display module 2140 may visually provide information to the user. The display module 2140 may include the display panel 2141, a scan driver 2142 and the data driver 2143. The display module 2140 may further include a window, a chassis, and a bracket for protecting the display panel 2141.

The display panel 2141 may include a liquid crystal display panel, an organic light-emitting display panel or an inorganic light-emitting display panel, but the type of the display panel 2141 is not limited thereto. The display panel 2141 may be a rigid type display panel, or a flexible type display panel capable of being rolled or folded. The display module 2140 may further include a supporter, a bracket or a heat dissipation member that supports the display panel 2141.

The scan driver 2142 may be mounted on the display panel 2141 as a driving chip. In another example, the scan driver 2142 may be integrated into the display panel 2141. For example, the scan driver 2142 may include an amorphous silicon TFT gate driver circuit ("ASG"), a low temperature polycrystalline silicon ("LTPS") TFT gate driver circuit or an oxide semiconductor TFT gate driver circuit ("OSG") embedded in the display panel 2141. The scan driver 2142 may receive a control signal from the controller and may output scan signals to the display panel 2141 in response to the control signal.

The display panel 2141 may further include an emission driver. The emission driver may output an emission control signal to the display panel 2141 in response to a control signal received from the controller. The emission driver may be formed separately from the scan driver 2142, or may be integrated into the scan driver 2142.

The data driver 2143 may receive a control signal from the controller, may convert image data into analog voltages (e.g., data voltages) in response to the control signal, and then may output the data voltages to the display panel 2141.

The data driver 2143 may be incorporated into other components (e.g., the controller). Further, the functions of the interface conversion circuit and the timing control circuit of the controller described above may be integrated into the data driver 2143.

The display module 2140 may further include a voltage generator circuit. The voltage generator circuit may output various voltages used to drive the display panel 2141.

The power management module 2150 may supply power to the components of the electronic device 2101. The power management module 2150 may include a battery that charges a power supply voltage. The battery may include a primary cell that is not rechargeable, a secondary cell that is rechargeable, or a fuel cell. The power management module 2150 may include a power management integrated circuit ("PMIC"). The PMIC may supply optimal power to each of the modules described above and modules described below. The power management module 2150 may include a wireless power transmission/reception member electrically connected to the battery. The wireless power transmission/reception member may include a plurality of antenna radiators in the form of coils.

The electronic device 2101 may further include the internal module 2160 and the external module 2170. The internal module 2160 may include the sensor module 2161, the antenna module 2162, and the sound output module 2163. The external module 2170 may include the camera module 2171, a light module 2172, and the communication module 2173.

The sensor module 2161 may detect an input by the user's body or an input by the pen of the first input module 2131, and may generate an electrical signal or data value corresponding to the input. The sensor module 2161 may include at least one of the fingerprint sensor 2161-1, the input sensor 2161-2, or a digitizer 2161-3.

The fingerprint sensor 2161-1 may generate a data value corresponding to the user's fingerprint. The fingerprint sensor 2161-1 may include any one of an optical type fingerprint sensor or a capacitive type fingerprint sensor.

The input sensor 2161-2 may generate a data value corresponding to coordinate information of the input by the user's body or the input by the pen. The input sensor 2161-2 may convert a capacitance change caused by the input into the data value. The input sensor 2161-2 may detect the input by the passive pen, or may transmit/receive data to/from the active pen.

The input sensor 2161-2 may measure a bio-signal, such as blood pressure, moisture, or body fat. For example, when a portion of the body of the user touches a sensor layer or a sensing panel, and does not move for a certain period of time, the input sensor 2161-2 may output information desired by the user to the display module 2140 by detecting the bio-signal based on a change in electric field due to the portion of the body.

The digitizer 2161-3 may generate a data value corresponding to coordinate information of the input by the pen. The digitizer 2161-3 may convert an amount of an electromagnetic change caused by the input into the data value. The digitizer 2161-3 may detect the input by the passive pen, or may transmit/receive data to/from the active pen.

At least one of the fingerprint sensor 2161-1, the input sensor 2161-2, or the digitizer 2161-3 may be implemented as a sensor layer formed on the display panel 2141 through a continuous process. The fingerprint sensor 2161-1, the input sensor 2161-2 and the digitizer 2161-3 may be located above the display panel 2141, or at least one of the fingerprint sensor 2161-1, the input sensor 2161-2, or the digitizer 2161-3 may be located below the display panel 2141.

Two or more of the fingerprint sensor 2161-1, the input sensor 2161-2, and/or the digitizer 2161-3 may be integrated into one sensing panel through the same process. When integrated into one sensing panel, the sensing panel may be located between the display panel 2141 and a window located above the display panel 2141. In some embodiments, the sensing panel may be located on the window, but the location of the sensing panel is not limited thereto.

At least one of the fingerprint sensor 2161-1, the input sensor 2161-2, or the digitizer 2161-3 may be embedded in the display panel 2141. In other words, at least one of the fingerprint sensor 2161-1, the input sensor 2161-2, or the digitizer 2161-2 may be simultaneously formed with the display panel 2141 through a process of forming elements (e.g., light-emitting elements, transistors, etc.) included in the display panel 2141.

In addition, the sensor module 2161 may generate an electrical signal or a data value corresponding to an internal state or an external state of the electronic device 2101. The sensor module 2161 may further include, for example, a gesture sensor, a gyro sensor, an atmospheric pressure sensor, a magnetic sensor, an acceleration sensor, a grip sensor, a proximity sensor, a color sensor, an infrared ("IR") sensor, a biometric sensor, a temperature sensor, a humidity sensor, or an illuminance sensor.

The antenna module 2162 may include one or more antennas for transmitting or receiving a signal or power to or from the outside. In some embodiments, the communication module 2173 may transmit or receive a signal to or from the external electronic device 2102 through an antenna suitable for a communication method. An antenna pattern of the antenna module 2162 may be integrated into one component (e.g., the display panel 2141) of the display module 2140 or the input sensor 2161-2.

The sound output module 2163 may output sound signals to the outside of the electronic device 2101. The sound output module 2163 may include, for example, a speaker or a receiver. The speaker may be used for general purposes, such as playing multimedia or playing record. The receiver may be used for receiving incoming calls. In some embodiments, the receiver may be implemented as separate from, or as part of the speaker. A sound output pattern of the sound output module 2163 may be integrated into the display module 2140.

The camera module 2171 may capture a still image and a moving image. In some embodiments, the camera module 2171 may include one or more lenses, an image sensor, or an image signal processor. The camera module 2171 may further include an infrared camera capable of measuring the presence or absence of the user, the user's location, and the user's line of sight.

The light module 2172 may provide light. The light module 2172 may include a light-emitting diode or a xenon lamp. The light module 2172 may operate in conjunction with the camera module 2171, or may operate independently of the camera module 2171.

The communication module 2173 may support establishing a wired or wireless communication channel between the electronic device 2101 and the external electronic device 2102 and performing communication via the established communication channel. The communication module 2173 may include a wireless communication module (e.g., a cellular communication module, a short-range wireless communication module or a global navigation satellite system ("GNSS") communication module) or a wired communication module (e.g., a local area network ("LAN") communication module or a power line communication ("PLC") module). The communication module 2173 may communicate with the external electronic device 2102 via a short-range communication network (e.g., Bluetooth^{™} (Bluetooth^{™} being a registered trademark of Bluetooth Sig, Inc., Kirkland, WA), wireless-fidelity (Wi-Fi^{®}) direct (Wi-Fi^{®} being a registered trademark of the non-profit Wi-Fi Alliance), or infrared data association ("IrDA")) or a long-range communication network (e.g., a cellular network, the Internet or a computer network (e.g., LAN or wide area network ("WAN"))). These various types of communication modules 2173 may be implemented as a single chip, or may be implemented as multi-chips separate from each other.

The input module 2130, the sensor module 2161, the camera module 2171, and the like may be used to control an operation of the display module 2140 in conjunction with the processor 2110.

The processor 2110 may output a command or data to the display module 2140, the sound output module 2163, the camera module 2171, or the light module 2172 based on input data received from the input module 2130. For example, the processor 2110 may generate image data corresponding to input data applied through a mouse or an active pen, and may output the image data to the display module 2140. Further, the processor 2110 may generate command data corresponding to the input data, and may output the command data to the camera module 2171 or the light module 2172. When no input data is received from the input module 2130 for a certain period of time, the processor 2110 may switch an operation mode of the electronic device 2101 to a low power mode or a sleep mode, thereby reducing power consumption of the electronic device 2101.

The processor 2110 may output a command or data to the display module 2140, the sound output module 2163, the camera module 2171, or the light module 2172 based on sensing data received from the sensor module 2161. For example, the processor 2110 may compare authentication data applied by the fingerprint sensor 2161-1 with authentication data stored in the memory 2120, and then may execute an application according to the comparison result. The processor 2110 may execute a command or output corresponding image data to the display module 2140 based on the sensing data sensed by the input sensor 2161-2 or the digitizer 2161-3. In a case where the sensor module 2161 includes a temperature sensor, the processor 2110 may receive temperature data from the sensor module 2161, and may further perform luminance correction on the image data based on the temperature data.

The processor 2110 may receive measurement data about the presence or absence of the user, the location of the user and the user's line of sight from the camera module 2171. The processor 2110 may further perform luminance correction on the image data based on the measurement data. For example, after the processor 2110 determines the presence or absence of the user based on the input from the camera module 2171, the data conversion circuit 2112-2 or the gamma correction circuit 2112-3 may perform the luminance correction on the image data, and the processor 2110 may provide the luminance-corrected image data to the display module 2140.

At least some of the above-described components may be coupled mutually and communicate signals (e.g., commands or data) therebetween via an interperipheral communication scheme (e.g., a bus, general purpose input and output ("GPIO"), serial peripheral interface ("SPI"), mobile industry processor interface ("MIPI") or ultra-path interconnect ("UPI")). The processor 2110 may communicate with the display module 2140 via an agreed interface. Further, any one of the above-described communication methods may be used between the processor 2110 and the display module 2140, but the communication method between the processor 2110 and the display module 2140 is not limited to the above-described communication method.

The electronic device 2101 according to various embodiments described above may be various types of devices. For example, the electronic device 2101 may include at least one of a portable communication device (e.g., a smart phone), a computer device, a portable multimedia device, a portable medical device, a camera, a wearable device, or a home appliance. However, the electronic device 2101 according to embodiments is not limited to the above-described devices.

The foregoing is illustrative of embodiments and is not to be construed as limiting thereof. Although a few embodiments have been described, those skilled in the art will readily appreciate that many modifications are possible in the embodiments without materially departing from the aspects of the present disclosure. Accordingly, all such modifications are intended to be included within the scope of the present disclosure as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims, with functional equivalents thereof to be included therein.

Embodiments are set out in the following clauses:
1. A display device comprising:
   a display panel comprising pixels;
   a data driver configured to provide data voltages to the pixels;
   a scan driver comprising stages configured to sequentially provide scan signals to the pixels; and
   a controller configured to control the data driver and the scan driver,
   wherein at least one stage of the stages comprises:
      an input circuit configured to transfer an input signal to a control node in response to a clock signal;
      a node-controlling circuit configured to provide a high gate voltage to an inverted control node when a voltage of the control node has a low level, and to provide a low gate voltage to the inverted control node when the voltage of the control node has a high level and the clock signal has the high level; and
      an output circuit configured to output the high gate voltage as a corresponding scan signal among the scan signals in response to a voltage of the inverted control node, and to output the low gate voltage as the corresponding scan signal in response to the voltage of the control node.
2. The display device of clause 1, wherein a time point at which the voltage of the inverted control node is changed from the high level to the low level is delayed by a low period of the clock signal from a time point at which the voltage of the control node is changed from the low level to the high level.
3. The display device of any clause 1 or clause 2, wherein a time point at which the voltage of the inverted control node is changed from the high level to the low level is delayed by half of a horizontal time from a time point at which the voltage of the control node is changed from the low level to the high level.
4. The display device of any preceding clause, wherein a time length of a high period of the corresponding scan signal is equal to a time length of a high period of the clock signal.
5. The display device of any preceding clause, wherein a high period of the corresponding scan signal of the at least one stage overlaps a high period of a scan signal of another stage among the stages during half of a horizontal time.
6. The display device of any preceding clause, wherein the node-controlling circuit comprises:
   a first transistor configured to provide the high gate voltage to the inverted control node when the voltage of the control node has the low level;
   a second transistor configured to be turned on when the clock signal has the high level; and
   a third transistor connected in series with the second transistor between the inverted control node and a line configured to transfer the low gate voltage, and configured to be turned on when the voltage of the control node has the low level.
7. The display device of clause 6, wherein the first transistor comprises a gate connected to the control node, a first terminal configured to receive the high gate voltage, and a second terminal connected to the inverted control node,
   wherein the second transistor comprises a gate configured to receive the clock signal, a first terminal connected to the inverted control node, and a second terminal, and
   wherein the third transistor comprises a gate connected to the control node, a first terminal connected to the second terminal of the second transistor, and a second terminal configured to receive the low gate voltage.
8. The display device of clause 6 or clause 7, wherein the first transistor is a P-type metal-oxide-semiconductor transistor, and
   wherein the second and third transistors are N-type metal-oxide-semiconductor transistors.
9. The display device of any of clauses 6 to 8, wherein the node-controlling circuit further comprises:
   a first capacitor configured to hold the voltage of the inverted control node; and
   a fourth transistor configured to provide the low gate voltage to the inverted control node in response to a reset signal.
10. The display device of clause 9, wherein the first capacitor comprises a first electrode configured to receive the high gate voltage, and a second electrode connected to the inverted control node, and
   wherein the fourth transistor comprises a gate configured to receive the reset signal, a first terminal connected to the inverted control node, and a second terminal configured to receive the low gate voltage.
11. The display device of any preceding clause, wherein the input circuit comprises a fifth transistor comprising a gate configured to receive the clock signal, a first terminal configured to receive the input signal, and a second terminal connected to the control node.
12. The display device of any preceding clause, wherein the at least one stage further comprises a sixth transistor at the control node to separate the control node into a first control node and a second control node.
13. The display device of clause 12, wherein the sixth transistor comprises a gate configured to receive the low gate voltage, a first terminal connected to the first control node, and a second terminal connected to the second control node.
14. The display device of clause 12 or clause 13, wherein the output circuit comprises:
   a seventh transistor comprising a gate connected to the inverted control node, a first terminal configured to receive the high gate voltage, and a second terminal connected to an output node for outputting the corresponding scan signal;
   a second capacitor comprising a first electrode connected to the second control node, and a second electrode connected to the output node; and
   an eighth transistor comprising a gate connected to the second control node, a first terminal connected to the output node, and a second terminal configured to receive the low gate voltage.
15. A display device comprising:
   a display panel comprising pixels;
   a data driver configured to provide data voltages to the pixels;
   a scan driver comprising stages configured to sequentially provide scan signals to the pixels; and
   a controller configured to control the data driver and the scan driver,
   wherein at least one stage of the stages comprises:
      a first transistor comprising a gate connected to a first control node, a first terminal configured to receive a high gate voltage, and a second terminal connected to an inverted control node;
      a second transistor comprising a gate configured to receive a clock signal, a first terminal connected to the inverted control node, and a second terminal;
      a third transistor comprising a gate connected to a second control node, a first terminal connected to the second terminal of the second transistor, and a second terminal configured to receive a low gate voltage;
      a first capacitor comprising a first electrode configured to receive the high gate voltage, and a second electrode connected to the inverted control node;
      a fourth transistor comprising a gate configured to receive a reset signal, a first terminal connected to the inverted control node, and a second terminal configured to receive the low gate voltage;
      a fifth transistor comprising a gate configured to receive the clock signal, a first terminal configured to receive an input signal, and a second terminal connected to the first control node;
      a sixth transistor comprising a gate configured to receive the low gate voltage, a first terminal connected to the first control node, and a second terminal connected to the second control node;
      a seventh transistor comprising a gate connected to the inverted control node, a first terminal configured to receive the high gate voltage, and a second terminal connected to an output node for outputting a corresponding scan signal;
      a second capacitor comprising a first electrode connected to the second control node, and a second electrode connected to the output node; and
      an eighth transistor comprising a gate connected to the second control node, a first terminal connected to the output node, and a second terminal configured to receive the low gate voltage.
16. The display device of clause 15, wherein a time length of a high period of the corresponding scan signal is equal to a time length of a high period of the clock signal.
17. The display device of clause 15 or clause 16, wherein a high period of the corresponding scan signal of the at least one stage overlaps a high period of a scan signal of another stage among the stages during half of a horizontal time.
18. An electronic device comprising:
   a processor configured to provide input image data; and
   a display device configured to display an image based on the input image data, the display device comprising:
      a display panel comprising a first pixel and a second pixel arranged in an N-th pixel row, N being an integer that is greater than or equal to 1;
      a data driver configured to provide data voltages to the first and second pixels;
      a scan driver comprising stages configured to sequentially provide scan signals to the first and second pixels; and
      a controller configured to control the data driver and the scan driver,
   wherein the first pixel comprises:
      a first storage capacitor; and
      a second pixel transistor configured to transfer a first data voltage from a data line to the first storage capacitor in response to an N-th scan signal among the scan signals,
   wherein the second pixel comprises:
      a second storage capacitor; and
      second-first and second-second pixel transistors connected in series between the data line and the second storage capacitor, and configured to transfer a second data voltage from the data line to the second storage capacitor in response to the N-th scan signal and an (N+1)-th scan signal among the scan signals, and
   wherein an N-th stage of the stages comprises:
      an input circuit configured to transfer an input signal to a control node in response to a clock signal;
      a node-controlling circuit configured to provide a high gate voltage to an inverted control node when a voltage of the control node has a low level, and to provide a low gate voltage to the inverted control node when the voltage of the control node has a high level and the clock signal has the high level; and
      an output circuit configured to output the high gate voltage as the N-th scan signal in response to a voltage of the inverted control node, and to output the low gate voltage as the N-th scan signal in response to the voltage of the control node.
19. The electronic device of clause 18, wherein each of the first pixel and the second pixel further comprises:
   a first pixel transistor configured to generate a driving current based on the first data voltage stored in the first storage capacitor or the second data voltage stored in the second storage capacitor;
   a third pixel transistor configured to provide an initialization voltage in response to the N-th scan signal; and
   a light-emitting element configured to emit light based on the driving current.
20. The electronic device of clause 18 or clause 19, wherein the N-th stage further comprises a sixth transistor configured to separate the control node into a first control node and a second control node,
   wherein the node-controlling circuit comprises:
      a first transistor comprising a gate connected to the first control node, a first terminal configured to receive the high gate voltage, and a second terminal connected to the inverted control node;
      a second transistor comprising a gate configured to receive the clock signal, a first terminal connected to the inverted control node, and a second terminal;
      a third transistor comprising a gate connected to the second control node, a first terminal connected to the second terminal of the second transistor, and a second terminal configured to receive the low gate voltage;
      a first capacitor comprising a first electrode configured to receive the high gate voltage, and a second electrode connected to the inverted control node; and
      a fourth transistor comprising a gate configured to receive a reset signal, a first terminal connected to the inverted control node, and a second terminal configured to receive the low gate voltage,
   wherein the input circuit comprises a fifth transistor comprising a gate configured to receive the clock signal, a first terminal configured to receive an input signal, and a second terminal connected to the first control node, and
   wherein the output circuit comprises:
      a seventh transistor comprising a gate connected to the inverted control node, a first terminal configured to receive the high gate voltage, and a second terminal connected to an output node for outputting the N-th scan signal;
      a second capacitor comprising a first electrode connected to the second control node, and a second electrode connected to the output node; and
      an eighth transistor comprising a gate connected to the second control node, a first terminal connected to the output node, and a second terminal configured to receive the low gate voltage.

## Claims

1. A display device comprising:
a display panel comprising pixels;
a data driver configured to provide data voltages to the pixels;
a scan driver comprising stages configured to sequentially provide scan signals to the pixels; and
a controller configured to control the data driver and the scan driver,
wherein at least one stage (100) of the stages comprises:
an input circuit (120) configured to transfer an input signal (SIN) to a control node (Q) in response to a clock signal (CLK);
a node-controlling circuit (140) configured to provide a high gate voltage (VGH) to an inverted control node (QB) when a voltage of the control node (Q) has a low level, and to provide a low gate voltage (VGL) to the inverted control node (QB) when the voltage of the control node (Q) has a high level and the clock signal (CLK) has the high level; and
an output circuit (160) configured to output the high gate voltage (VGH) as a corresponding scan signal (SCAN) among the scan signals in response to a voltage of the inverted control node (QB), and to output the low gate voltage (VGL) as the corresponding scan signal (SCAN) in response to the voltage of the control node (Q).

2. The display device of claim 1, wherein the node-controlling circuit (140) is configured such that a time point at which the voltage of the inverted control node (QB) is changed from the high level to the low level is delayed by a low period of the clock signal (CLK) from a time point at which the voltage of the control node (Q) is changed from the low level to the high level.

3. The display device of claim 1 or claim 2, wherein the node-controlling circuit (140) is configured such that a time point at which the voltage of the inverted control node (QB) is changed from the high level to the low level is delayed by half of a horizontal time from a time point at which the voltage of the control node (Q) is changed from the low level to the high level.

4. The display device of any preceding claim, wherein the output circuit (160) is configured such that a time length of a high period of the corresponding scan signal (SCAN) is equal to a time length of a high period of the clock signal (CLK).

5. The display device of any preceding claim, wherein the output circuit (160) is configured such that a high period of the corresponding scan signal (SCAN) of the at least one stage (100) overlaps a high period of a scan signal of another stage among the stages during half of a horizontal time.

6. The display device of any preceding claim, wherein the node-controlling circuit (140) comprises:
a first transistor (T1) configured to provide the high gate voltage (VGH) to the inverted control node (QB) when the voltage of the control node (Q) has the low level;
a second transistor (T2) configured to be turned on when the clock signal (CLK) has the high level; and
a third transistor (T3) connected in series with the second transistor (T2) between the inverted control node (QB) and a line configured to transfer the low gate voltage (VGL), and configured to be turned on when the voltage of the control node (Q) has the low level,
wherein optionally: the first transistor (T1) is a P-type metal-oxide-semiconductor transistor, and the second (T2) and third transistors (T3) are N-type metal-oxide-semiconductor transistors.

7. The display device of claim 6, wherein the first transistor (T1) comprises a gate connected to the control node (Q), a first terminal configured to receive the high gate voltage (VGH), and a second terminal connected to the inverted control node (QB),
wherein the second transistor (T2) comprises a gate configured to receive the clock signal (CLK), a first terminal connected to the inverted control node (QB), and a second terminal, and
wherein the third transistor (T3) comprises a gate connected to the control node (Q), a first terminal connected to the second terminal of the second transistor (T2), and a second terminal configured to receive the low gate voltage (VGL).

8. The display device of claim 6 or claim 7, wherein the node-controlling circuit (140) further comprises:
a first capacitor (C1) configured to hold the voltage of the inverted control node (QB); and
a fourth transistor (T4) configured to provide the low gate voltage (VGL) to the inverted control node (T4) in response to a reset signal (ESR).

9. The display device of claim 8, wherein the first capacitor (C1) comprises a first electrode configured to receive the high gate voltage (VGH), and a second electrode connected to the inverted control node (QB), and
wherein the fourth transistor (T4) comprises a gate configured to receive the reset signal (ESR), a first terminal connected to the inverted control node (QB), and a second terminal configured to receive the low gate voltage (VGL).

10. The display device of any preceding claim, wherein the input circuit (120) comprises a fifth transistor (T5) comprising a gate configured to receive the clock signal (CLK), a first terminal configured to receive the input signal (SIN), and a second terminal connected to the control node (Q).

11. The display device of any preceding claim, wherein the at least one stage (100) further comprises a sixth transistor (T6) at the control node (Q) to separate the control node (Q) into a first control node (Q1) and a second control node (Q2),
wherein the sixth transistor (T6) optionally comprises a gate configured to receive the low gate voltage (VGL), a first terminal connected to the first control node (Q1), and a second terminal connected to the second control node (Q2).

12. The display device of claim 11, wherein the output circuit (160) comprises:
a seventh transistor (T7) comprising a gate connected to the inverted control node (QB), a first terminal configured to receive the high gate voltage (VGH), and a second terminal connected to an output node (NO) for outputting the corresponding scan signal (SCAN);
a second capacitor (C2) comprising a first electrode connected to the second control node (Q2), and a second electrode connected to the output node (NO); and
an eighth transistor (T8) comprising a gate connected to the second control node (Q2), a first terminal connected to the output node (NO), and a second terminal configured to receive the low gate voltage (VGL).

13. A display device comprising:
a display panel comprising pixels;
a data driver configured to provide data voltages to the pixels;
a scan driver comprising stages configured to sequentially provide scan signals to the pixels; and
a controller configured to control the data driver and the scan driver,
wherein at least one stage (100) of the stages comprises:
a first transistor (T1) comprising a gate connected to a first control node (Q1), a first terminal configured to receive a high gate voltage (VGH), and a second terminal connected to an inverted control node (QB);
a second transistor (T2) comprising a gate configured to receive a clock signal (CLK), a first terminal connected to the inverted control node (QB), and a second terminal;
a third transistor (T3) comprising a gate connected to a second control node (Q2), a first terminal connected to the second terminal of the second transistor (T2), and a second terminal configured to receive a low gate voltage (VGL);
a first capacitor (C1) comprising a first electrode configured to receive the high gate voltage (VGH), and a second electrode connected to the inverted control node (QB);
a fourth transistor (T4) comprising a gate configured to receive a reset signal (ESR), a first terminal connected to the inverted control node (QB), and a second terminal configured to receive the low gate voltage (VGL);
a fifth transistor (T5) comprising a gate configured to receive the clock signal (CLK), a first terminal configured to receive an input signal (SIN), and a second terminal connected to the first control node (Q1);
a sixth transistor (T6) comprising a gate configured to receive the low gate voltage (VGL), a first terminal connected to the first control node (Q1), and a second terminal connected to the second control node (Q2);
a seventh transistor (T7) comprising a gate connected to the inverted control node (QB), a first terminal configured to receive the high gate voltage (VGH), and a second terminal connected to an output node (NO) for outputting a corresponding scan signal (SCAN);
a second capacitor (C2) comprising a first electrode connected to the second control node (Q2), and a second electrode connected to the output node (NO); and
an eighth transistor (T8) comprising a gate connected to the second control node (Q2), a first terminal connected to the output node (NO), and a second terminal configured to receive the low gate voltage (VGL).

14. An electronic device comprising:
a processor configured to provide input image data; and
a display device according to any of claims 1 to 12, wherein:
the display panel comprises a first pixel (PX1) and a second pixel (PX2) arranged in an N-th pixel row, N being an integer that is greater than or equal to 1;
the data driver is configured to provide data voltages to the first and second pixels; and
the scan driver comprises stages configured to sequentially provide scan signals to the first (PX1) and second pixels (PX2),
wherein the first pixel (PX1) comprises:
a first storage capacitor (CST1); and
a second pixel transistor (PXT2) configured to transfer a first data voltage from a data line (DL) to the first storage capacitor (CST1) in response to an N-th scan signal among the scan signals,
wherein the second pixel (PX2) comprises:
a second storage capacitor (CST2); and
second-first (PXT2-1) and second-second (PXT2-2) pixel transistors connected in series between the data line (DL) and the second storage capacitor (CST2), and configured to transfer a second data voltage from the data line (DL) to the second storage capacitor (CST2) in response to the N-th scan signal and an (N+1)-th scan signal among the scan signals, and
wherein the output circuit (160) of an N-th stage of the stages is configured to output the high gate voltage (VGH) as the N-th scan signal (SCAN[N]) in response to a voltage of the inverted control node (QB), and to output the low gate voltage (VGL) as the N-th scan signal (SCAN[N]) in response to the voltage of the control node (Q).

15. The electronic device of claim 14, wherein each of the first pixel (PX1) and the second pixel (PX2) further comprises:
a first pixel transistor (PXT1) configured to generate a driving current based on the first data voltage stored in the first storage capacitor (CST1) or the second data voltage stored in the second storage capacitor (CST2);
a third pixel transistor (PXT3) configured to provide an initialization voltage (VINT) in response to the N-th scan signal (SCAN[N]); and
a light-emitting element configured to emit light based on the driving current.

16. The electronic device of claim 14 or claim 15, wherein the N-th stage further comprises a sixth transistor (T6) configured to separate the control node (Q) into a first control node (Q1) and a second control node (Q2),
wherein the node-controlling circuit (140) comprises:
a first transistor (T1) comprising a gate connected to the first control node (Q1), a first terminal configured to receive the high gate voltage (VGH), and a second terminal connected to the inverted control node (QB);
a second transistor (T2) comprising a gate configured to receive the clock signal (CLK), a first terminal connected to the inverted control node (QB), and a second terminal;
a third transistor (T3) comprising a gate connected to the second control node (Q2), a first terminal connected to the second terminal of the second transistor (T2), and a second terminal configured to receive the low gate voltage (VGL);
a first capacitor (C1) comprising a first electrode configured to receive the high gate voltage (VGH), and a second electrode connected to the inverted control node (QB); and
a fourth transistor (T4) comprising a gate configured to receive a reset signal (ESR), a first terminal connected to the inverted control node (QB), and a second terminal configured to receive the low gate voltage (VGL),
wherein the input circuit (120) comprises a fifth transistor (T5) comprising a gate configured to receive the clock signal (CLK), a first terminal configured to receive an input signal (SIN), and a second terminal connected to the first control node (Q1), and
wherein the output circuit (160) comprises:
a seventh transistor (T7) comprising a gate connected to the inverted control node (QB), a first terminal configured to receive the high gate voltage (VGH), and a second terminal connected to an output node (NO) for outputting the N-th scan signal (SCAN[N]);
a second capacitor (C2) comprising a first electrode connected to the second control node (Q2), and a second electrode connected to the output node (NO); and
an eighth transistor (T8) comprising a gate connected to the second control node (Q2), a first terminal connected to the output node (NO), and a second terminal configured to receive the low gate voltage (VGL).
